# EUROPEAN PATENT APPLICATION

(11) **EP 3 026 441 A1**
(43) Date of publication of application: **01.06.2016**
(21) Application number: 14290357.4
(22) Date of filing: 27.11.2014
(51) Int. Cl.: G01R 1/24, H01P 5/18, H03G 3/30

(54) **Apparatus for measuring RF power and associated methods**

(71) Applicant: NXP B.V., 5656 AG Eindhoven (NL)
(72) Inventor: Herbert, Arnaud, Redhill, Surrey RH1 1SH (GB)
(74) Representative: Miles, John Richard

(57) **Abstract**

An RF power sensor apparatus (300) comprising: a first input-side terminal (310) and a second input-side terminal (312) for connecting to spaced apart regions of an RF transmission line (302); a directional coupler comprising: an input-side coupling line (320) connected to the first input-side terminal (310) via a first capacitor (322) and connected to the second input-side terminal (312) via a second capacitor (324); and an output-side coupling line (330) connected to a first output-side terminal (332) and a second output-side terminal (334); wherein the input-side coupling line (320) is configured to be electromagnetically coupled to the output-side coupling line (330), when in use; and a sensor (340) connected to the first output-side terminal (332) and the second output-side terminal (334), the sensor (340) configured to sense an RF power coupled from the input-side coupling line (320) to the output-side coupling line (330) when the first input-side terminal (310) and second input-side terminal (312) are coupled to an RF transmission line (302) transmitting RF power.

## Description

The present disclosure relates to apparatus and methods for measuring the power of RF (Radio Frequency) signals being transmitted through a transmission line.

An RF signal may be provided by a signal generator to an antenna via a transmission line. The amount of RF power transmitted by the antenna will depend on matching the impedance of the load. Where a mismatch occurs, RF power may be reflected from the antenna back through the transmission line to the signal generator. The reflected power, while reducing the efficiency of the system, may also cause damage to the signal generator. Therefore, it is desirable to have an apparatus capable of measuring RF power being transmitted in a particular direction between an antenna and a signal generator, such that the transmitted power may be monitored and, if necessary, adapted based on such measurements.

According to a first aspect of the disclosure there is provided an RF power sensor apparatus comprising: a first input-side terminal and a second input-side terminal for connecting to spaced apart regions of an RF transmission line; a directional coupler comprising: an input-side coupling line connected to the first input-side terminal via a first capacitor and connected to the second input-side terminal via a second capacitor; and an output-side coupling line connected to a first output-side terminal and a second output-side terminal; wherein the input-side coupling line is configured to be electromagnetically coupled to the output-side coupling line, when in use; and a sensor connected to the first output-side terminal and the second output-side terminal, the sensor configured to sense an RF power coupled from the input-side coupling line to the output-side coupling line when the first input-side terminal and second input-side terminal are coupled to an RF transmission line transmitting RF power.

Advantageously, coupling the first input-side terminal and the second input-side terminal to an RF power transmission line via respective capacitors may enable a small proportion of the RF power to be coupled to the directional coupler. By coupling only a small proportion of the RF power, the RF power sensor apparatus may be small and inexpensive while capable of measuring RF powers of hundreds of Watts or even kilowatts flowing through an RF transmission line.

The RF power sensor apparatus may be selectively configured to sense: a forward RF power flowing from the first input-side terminal to the second input-side terminal; a reflected RF power flowing from the second input-side terminal to the first input-side terminal; and a phase angle between the forward RF power and the reflected RF power.

The sensor may be connected to the first output-side terminal and the second output-side terminal by a switching component comprising: a first switch configured to selectively couple the first output-side terminal to either the sensor or a first impedance; a second switch configured to selectively couple the second output-side terminal to either the sensor or a second impedance. By connecting the first switch to the senor and the second switch to the second impedance, the apparatus may be configured to sense RF power flowing in one direction. By connecting the first switch to the first impedance and the second switch to the sensor the apparatus may be configured to sense RF power flowing in the other direction.

The switching component may further comprise a third switch configured to selectively couple the sensor to either the first switch or the second switch.

The output-side coupling line may be one of: less than 2mm, less than 1 mm, less than 0.5mm, less than 0.2mm, or less than 0.1 mm, in length.

The capacitance of the first capacitor may be equal to the capacitance of the second capacitor.

The input-side coupling line may be capacitively and/or inductively coupled to the output-side coupling line.

The apparatus may be configured to sense an RF power in the Gigahertz frequency range. The apparatus may be configured to sense an RF power in the 2.4GHz to 2.5GHz frequency range, or in the 5.725GHz to 5.875GHz frequency range, or in the 902MHz to 928MHz frequency range.

The apparatus may be configured to sense an RF power in the 100W to 10kW power range.

The apparatus may be configured, when connected to an RF transmission line transmitting RF power, to couple less than 1%, or less than 0.1%, or less than 0.01%, or less than 0.001 %, or less than 0.0001 %, of the transmitted RF power from the RF transmission line to the sensor.

The sensor may comprise an IQ modulator and/or a diode.

The RF power sensor apparatus may be configured to: sense a forward RF power flowing from the first input-side terminal to the second input-side terminal; and/or sense a reflected RF power flowing from the second input-side terminal to the first input-side terminal.

There may be provided an integrated circuit comprising the RF power sensor apparatus.

There may be provided a device comprising an RF signal generator coupled to an antenna by an RF transmission line, the signal generator may be configured to supply RF power to the antenna via the RF transmission line, the device may further comprise an RF power sensor apparatus comprising: a first input-side terminal and a second input-side terminal connected to spaced apart regions of the RF transmission line; a directional coupler comprising: an input-side coupling line connected to the first input-side terminal via a first capacitor and connected to the second input-side terminal via a second capacitor; and an output-side coupling line connected to a first output-side terminal and a second output-side terminal; wherein the input-side coupling line may be configured to be electromagnetically coupled to the output-side coupling line, when in use; and a sensor connected to the first output-side terminal and the second output-side terminal, the sensor may be configured to sense an RF power coupled from the input-side coupling line to the output-side coupling line when the RF transmission line is transmitting RF power; wherein, the device may be configured to adapt the supply of RF power to the antenna, based on the sensed RF power.

There may be provided a device comprising the RF power sensor apparatus, wherein the device may be configured to provide RF heating or RF communications signalling.

A description is now given, by way of example only, with reference to the accompanying drawings, in which:
Figure 1 shows a schematic diagram of an RF power transmitter with a power measurement system;
Figure 2 shows a schematic diagram of a directional coupler;
Figure 3 shows a schematic diagram of an RF power sensor apparatus;
Figure 4 shows a simulated circuit suitable for performing computer simulations of a particular RF power sensor apparatus
Figure 5 shows a chart of data generated by a computer simulation of the performance of an RF power sensor apparatus with good impedance matching;
Figure 6 shows a chart of data generated by a computer simulation of the performance of an RF power sensor apparatus with a significant impedance mismatch.

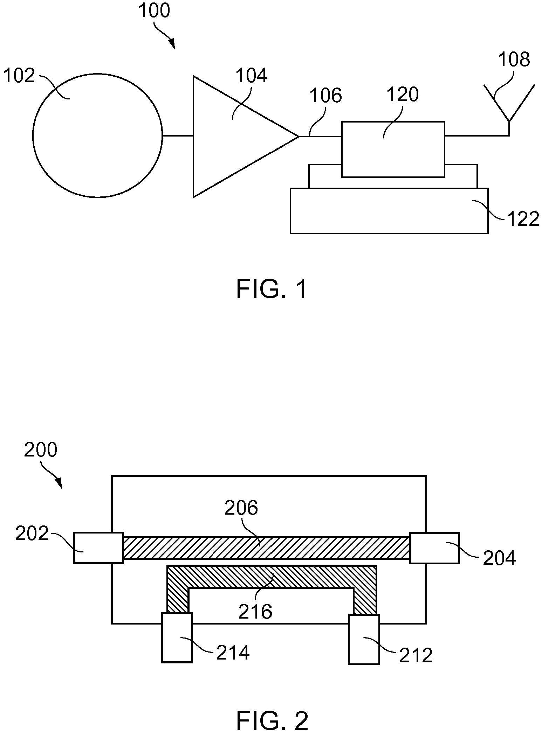

Figure 1 illustrates an RF power transmitter 100. In this disclosure, RF power includes electromagnetic waves with a frequency anywhere between approximately 3kHz and approximately 300GHz. The power transmitter 100 comprises a signal generator 102 configured to supply an RF signal to a power amplifier 104, in this case. The power amplifier 104 amplifies the RF signal to a high power, such as hundreds or thousands of Watts. The high power RF signal is then supplied to an antenna 108 via a transmission line 106. In order to measure the power transmitted by the transmission line 106, the RF power transmitter 100 further comprises a directional coupler 120, coupled to a power sensor 122.

Figure 2 illustrates a directional coupler 200 similar to the directional coupler 120 disclosed above in relation to figure 1. The directional coupler 200 is a four-port device. A first port 202 is connected to a second port 204 via an input-side coupling line 206. A third port 212 is connected to a fourth port 214 via an output-side coupling line 216. It will be appreciated that the connections between the first port and the second port, and indeed the third port and the fourth port may be achieved by different means depending on the frequency of RF power that a particular directional coupler if configured to operate at. In some examples, the connection may be provided by a metal track that galvanically connects respective ports. In other examples, configured to operate at higher frequencies within the microwave spectrum, the connections may be provided for by waveguides. In this example, where conductive metal tracks are shown, the close proximity of the input-side coupling line 206 to the output-side coupling line 216 provides for a capacitive coupling between the input-side coupling line 206 and the output side-coupling line 216. In use, the first port 202 may be connected to a signal generator while the second port 204 may be connected to an antenna. RF power transmitted from the signal generator to the antenna, and any power reflected from the antenna back to the signal generator, will be transmitted through the directional coupler 200. The capacitive coupling enables a certain proportion of the RF power entering the first port 202, or the second port 204, to be coupled to the third port 212 or the fourth port 214. When the third port 212 and the forth port 214 are appropriately connected to a power meter, the power flowing through the input-side coupling line 206 can thereby be determined.

It will be appreciated that a variety of different designs of directional coupler may be used. In some examples, the coupling of the input-side coupling line to the output-side coupling line may be inductive and/or galvanic as well as capacitive. In examples where the coupling lines comprise waveguides the coupling between the input-coupling line and the output-coupling line may be achieved by means of a plurality of apertures connecting the interior or the input-coupling line waveguide to the interior of the output-coupling line waveguide. In some examples, power transmitted from the first port 202 to the second port 204, so-called forward power, may be coupled to the fourth port 214, while power transmitted from the second port 204 to the first port 202, so-called reflected power, may be coupled to the third port 212. In other examples the direction of coupling may be reversed such that power transmitted from the first port 202 to the second port 204 may be coupled to the third port 212, while power transmitted from the second port 204 to the first port 202 may be coupled to the fourth port 214. A directional coupler therefore enables separate measurement of forward power and reflected power to be made. Furthermore, measurements of both the amplitudes and respective phases of forward and reflected power can be made.

Where a directional coupler is used to provide for power measurements in a system configured to transmit high powers, such as hundreds or thousands of Watts, the directional coupler must be capable of handling these high powers. Consequently, the construction of such a directional coupler may be expensive and complicated. Further, the RF coaxial cables required to connect the directional coupler to the signal generator and antenna will also need to be capable of handling these high powers, and will therefore also be costly components.

Many directional couplers are physically large components. In part, large size may be necessary in order to handle high power transmission. However, in many examples the length of the coupling lines will be approximately one quarter of the wavelength of the RF power to be measured. For a frequency band between 2.4GHz and 2.5GHz, which in some examples can be commercially significant, the wavelength of an RF signal is approximately 122mm. Therefore, the coupling lines for a directional coupler designed to operate in this frequency range may be approximately 30mm in length. These requirements for the size of directional couplers make it difficult or even impossible to fabricate a directional coupler as an integrated circuit.

Designs enabling the construction of small, cheap, and preferably integrated, circuits for measuring both forward and reverse RF power flowing through a transmission line, and in particular RF power in excess of hundreds or thousands of Watts, would therefore be desirable.

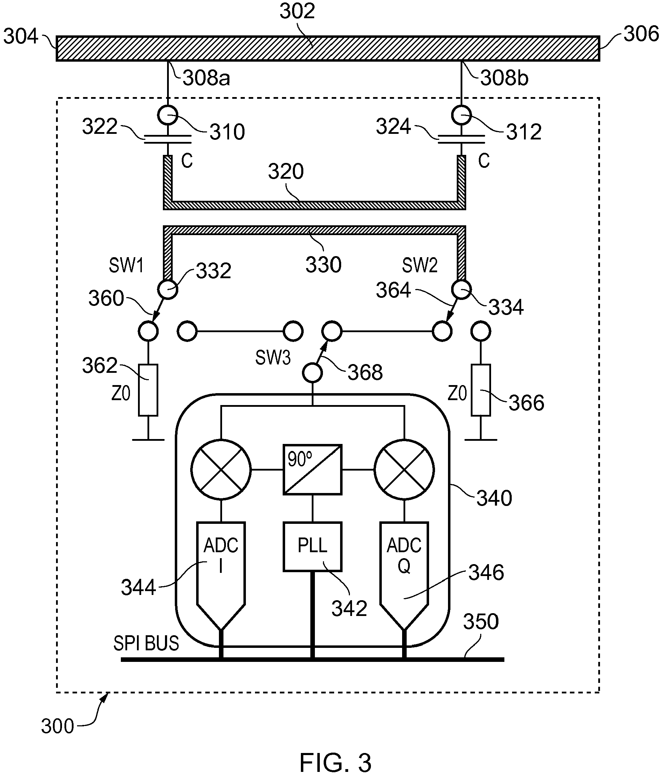

Figure 3 illustrates an RF power sensor apparatus 300 coupled to an RF transmission line 302. The RF transmission line 302 has a first end 304 which may be coupled to a signal generator (not shown) and a second end 306 which may be coupled to an antenna (not shown). Thereby, the RF transmission line 302 is configured to transmit forward RF power, from the first end 304 to the second end 306, and to transmit reflected RF power from the second end 306 to the first end 304.

The RF power sensor apparatus 300 comprises a first input-side terminal 310 and a second input-side terminal 312, which can be spaced apart from the first input-side terminal 310. The RF power sensor apparatus 300 may be coupled to the RF transmission line 302 by connecting the first input-side terminal 310 to a first part / region of the RF transmission line 308a and by connecting the second input-side terminal 312 to a second part / region of the RF transmission line 308b, wherein the first 308a and second 308b parts of the transmission line 302 are spaced apart from one another.

The RF power sensor apparatus 300 has a directional coupler comprising an input-side coupling line 320. The input-side coupling line 320 has a first end that is connected to the first input-side terminal 310 via a first capacitor 322, and a second end that is connected to the second input-side terminal 312 via a second capacitor 324. In some examples the capacitance of the first capacitor 322 may be equal to the capacitance of the second capacitor 324, while in other examples the capacitances may be different. The connection of the input-side coupling line 320 to the RF transmission line 302 via the first 322 and second 324 capacitors may enable some, but not all, of the RF power flowing through the RF transmission line 302 to flow into the input-side coupling line. For example, some proportion of RF power flowing from the first end of the transmission line 304 towards the second end of the transmission line 306 may by flow through the first capacitor 322 into the input-side coupling line 320 and then through the second capacitor 324 back out into the transmission line 302. The amount of RF power picked-up from the RF transmission line 302 depends on the losses between the input-side coupling line 320 and an output-side coupling line 330, which is discussed in more detail below. The current at the first end of the transmission line 304 (l304) is a sum of the currents (i) through the RF transmission line between the first 308a and second 308b parts of the transmission line (l302), (ii) through the input-side coupling line 320 (l320), and (iii) at a second end of the transmission line 306 (l306): l304=l302+l320=l306, in which case the insertion losses can be close to zero. The amount of RF power flowing into the input-side coupling line 320 from the RF transmission line 302 will be proportional to the power flowing through the RF transmission line 302. The proportion may be small. For example, the proportion may be less than 1%, or less than 0.1%, or less than 0.01%, or less than 0.001%, or less than 0.0001%, of the power flowing through the transmission line 302.

The appropriate value of the capacitance of the first 322 and second 324 capacitors will depend on the particular frequency band of RF power that the apparatus 300 is configured to sense. For example, where the apparatus 300 is configured to measure power in the 2.4GHz to 2.5GHz band, a suitable value of capacitance would be between 1 pico Farad and 1 nano Farad. Such capacitance values can provide acceptable levels of losses at the frequencies of interest. It will be appreciated that in other examples, configured to sense RF power at a lower frequency, larger values of capacitance will be more appropriate, while in examples configured to measure RF power at higher frequencies, smaller values of capacitance may be more suitable.

The directional coupler further comprises an output-side coupling line 330. The output-side coupling line 330 has a first end that is connected to a first output-side terminal 332, and a second end that is connected to a second output-side terminal 334. The input-side coupling line 320 may be electromagnetically coupled to the output-side coupling line 320 as described above in relation to the directional coupler shown in figure 2. It will be appreciated that any design of directional coupler may be employed in embodiments of the present disclosure. In the example of figure 3 the input-side coupling line 320 is electromagnetically coupled to the output-side coupling line 330, wherein the electromagnetic coupling is capacitive. In other examples (not shown) the electromagnetic coupling may be inductive. The electromagnetic coupling enables a proportion of the RF power flowing through the input-side coupling line 320 to be coupled across to the output-side coupling line 330 where it may be provided to either the first output-side terminal 332 or to the second output-side terminal 334, depending on the direction in which the RF power was flowing through the RF transmission line 302.

The RF power sensor apparatus 300 further comprises a sensor 340 connected to the first output-side terminal 332 and the second output-side terminal 334. It will be appreciated that in certain embodiments the output-side coupling line may be directly coupled to the sensor 340, whereas in figure 3 the first 332 and second 334 output-side terminals are coupled to the sensor 340 via switching components, which will be described in detail below.

In figure 3, the sensor 340 comprises an IQ modulator, with a Phase Locked Loop (PLL) 342 configured to provide an appropriate clock signal. The IQ modulator includes an in-phase analogue-to-digital (A-D) converter 344 configured to provide a digital signal representative of the amplitude of an in-phase component of the sensed RF power, and also a quadrature A-D converter 346 configured to provide a digital signal representative of the amplitude of a quadrature component of the sensed RF power. The digital signals may be provided to a Serial Peripheral Interface Bus 350, or to any other apparatus suitable for processing the digital signals.

In some examples the sensor may comprise a rectifier diode (not shown) or any other suitable apparatus configured to sense an RF power coupled from the input-side coupling line to the output-side coupling line when the first input-side terminal and second input-side terminal are coupled to an RF transmission line transmitting RF power.

In some examples, one of the first output-side terminal 332 or the second output-side terminal 334 may be permanently coupled to the sensor 340. Thereby, the RF power sensor apparatus 300 may be configured to sense a forward RF power flowing from the first input-side terminal to the second input-side terminal or it may be configured to sense a reflected RF power flowing from the second input-side terminal to the first input-side terminal.

In other examples, the RF power sensor apparatus 300 may be selectively configured to connect either the first output-side terminal 332 or the second output-side terminal 334 to the sensor 340. Such selective configuration may enable the RF power sensor apparatus to be controlled so that it either senses a forward RF power flowing from the first input-side terminal 332 to the second input-side terminal 334, or it seems a reflected RF power flowing from the second input-side terminal 334 to the first input-side terminal 332. Where the RF power sensor apparatus 300 may sense both forward and reflected RF power, it may also be configured to sense a phase angle between the forward RF power and the reflected RF power.

In figure 3, the coupling of the first output-side terminal 332 and the second output-side terminal 334 to the sensor 340 is via a switching component. The switching component comprises a first switch 360 configured to selectively couple the first output-side terminal 332 to either the sensor 340 or ground via a first impedance 362, depending on the position of the first switch 360. In figure 3 the first switch 360 is arranged to connect the first output-side terminal 332 to the first impedance 362. The switching component further comprises a second switch 364 configured to selectively couple the second output-side terminal 334 to either the sensor 340 or ground via a second impedance 366, depending on the position of the second switch 364. In figure 3 the second switch 364 is arranged to connect the second output-side terminal 334 to the sensor 340. With the first 360 and second 364 switches in the configuration shown in figure 3, the sensor 340 may receive reflected power from the RF transmission line 302. It will be appreciated that forward power may be supplied to the sensor 340 when the first switch 360 is connected to the sensor 340 and the second switch 364 is connected to the second impedance 366.

The value of the first impedance 362 and the second impedance 364 may be the same or different. The value of the first impedance 362 and the second impedance 364 may be selected to provide effective isolation of the output-side coupling line terminal to which it is configured to be coupled. In some examples, the value of the impedance may be 50 Ohms.

The first switch 360 and the second switch 364 may be controlled to switch between their respective states simultaneously. In this way one of the switches may be controlled to connect to its respective impedance while the other switch is controlled to connect to the sensor. Therefore, the sensor may be connected to only one of the first output-side terminal 332 or the second output-side terminal 334 at any particular time. The switches may be controlled in response to user input, or may be controlled automatically. In some examples the switches may be controlled to switch between respective states on a periodic basis. Thereby, the sensor may be configured to measure forward power and reflected power sequentially such that both forward power and reflected power may be monitored on a rapidly updated, periodic, basis.

In order to sense either forward power or reflected power, the sensor 340 may be connected to either the first output-side terminal 332 or the second output-side terminal 334 but not to both terminals simultaneously. In the example of figure 3, the switching component further comprises an optional third switch 368 configured to selectively couple the sensor 340 to either the first switch 360 or the second switch 364. The third switch 368 may thereby prevent simultaneous connection of the sensor to both ends of the output-side coupling line 330.

It will be appreciated that many different types of switch may be used in embodiments of the present disclosure. In some examples, the first switch 360 and the second switch 364, and if present, the third switch 368, may comprise transistors. The RF power sensor apparatus 300 may thereby be configured to switch rapidly between sensing forward and reflected power, and may thereby be able to provide real time data relating to the amplitude and phase of both the forward and reflected power.

The length of the input-side coupling line 320 and the output-side coupling line 330 may be significantly shorter than one quarter of the wavelength of the RF power to be sensed, if the power is being measured for a very thin bandwidth. For example, where the RF power sensor apparatus 300 is configured to sense power in the 2.4GHz to 2.5GHz frequency band, the input-side coupling line 320 and the output-side coupling line 330 may be approximately 0.1 mm in length, or may be less than 0.1 mm in length. It will be appreciated that other lengths may be appropriate depending on the particular frequency band that a particular RF power sensor apparatus is configured to sense. For example, the coupling lines may be less than 0.2mm or less than 0.5mm or less than 1 mm or less than 2mm in length.

The RF power sensor apparatus may be configured to sense RF power in the Gigahertz frequency range. In other embodiments the RF power sensor apparatus may be configured to sense RF power in the Megahertz range.

Since only a small proportion of the RF power being supplied to a transmission line can be coupled into the RF power sensor apparatus it may be configured to sense an RF power in a 100W to 10kW power range, without the RF power sensor apparatus itself being exposed to such high powers. This advantageously enables the RF power sensor apparatus to be small.

In some examples, the RF power sensor apparatus of the present disclosure may be provided as an integrated circuit. This may enable provision of RF power sensors that are cheap to manufacture and physically small and compact.

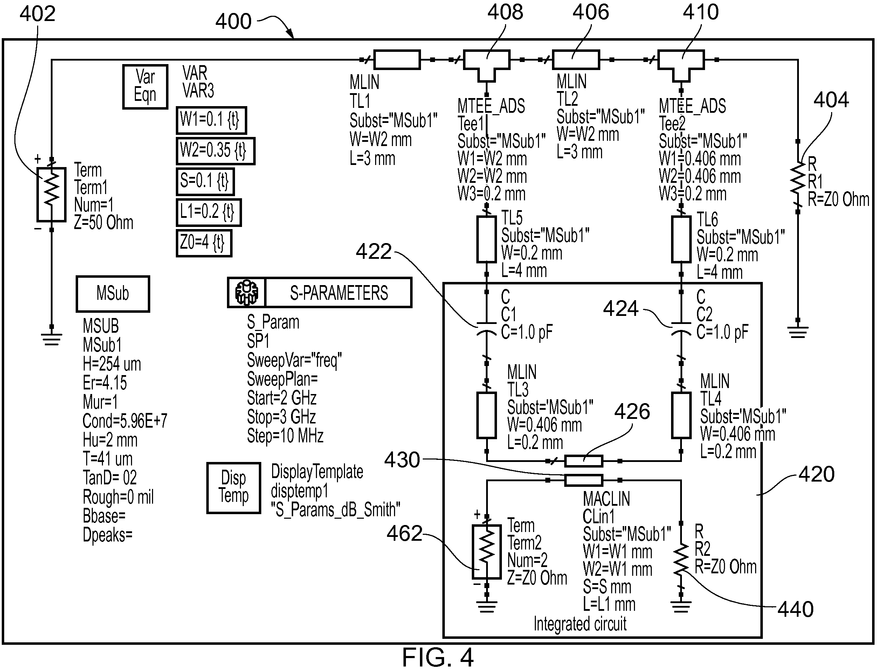

Figure 4 illustrates a simulated circuit 400 for performing a computer simulation of an embodiment of the present disclosure. The simulated circuit 400 includes a signal generator 402 for providing RF power to a load 404 via a transmission line 406 at frequencies ranging from 2GHz to 3GHz, in steps of 10MHz. The simulated circuit 400 includes an RF power sensor apparatus 420. The RF power sensor apparatus 420 comprises a first capacitor 422 connected to a first part of the transmission line 408 and a second capacitor 424 coupled to a second part of the transmission line 410. Both capacitors have a capacitance of 1.0pF. The RF power sensor apparatus 420 does not comprise any switches of the sort disclosed in relation to figure 3 above. The simulation is thereby performed with a single configuration of circuit, arranged to sense reflected power only.

The first capacitor 422 and the second capacitor 424 are connected to an input-side coupling line 426. The input-side coupling line 426 is capacitively coupled to an output-side coupling line 430. The output-side coupling line 430 is coupled to ground via a first impedance 462 and to a sensor 440 such that the sensor 440 is configured to measure the reflected power flowing in the transmission line 406.

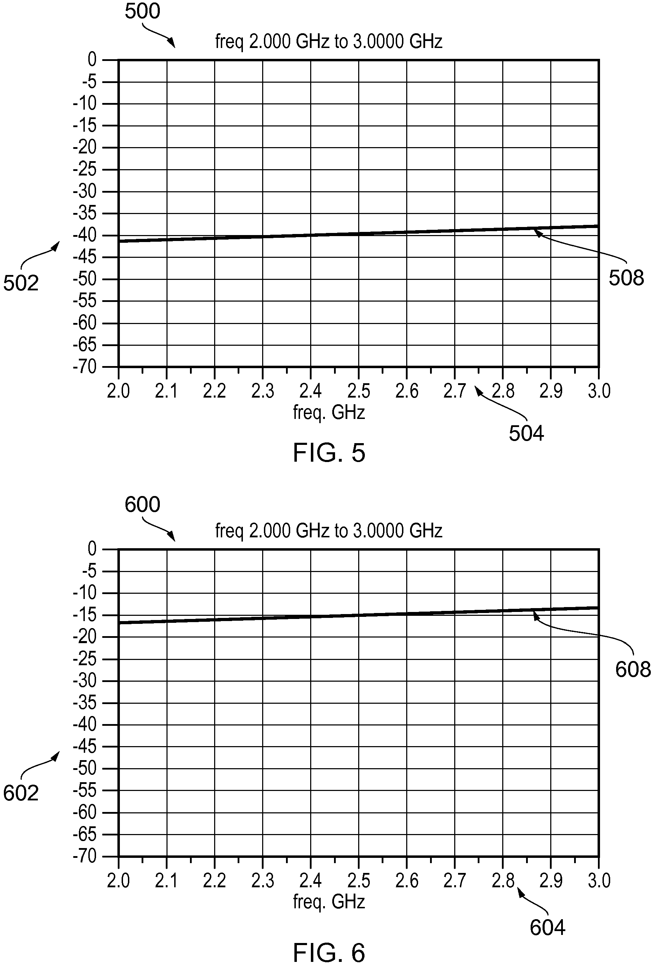

Figure 5 shows a chart 500 illustrating the results of a simulation performed using the simulated circuit 400 of figure 4. The chart shows power on a vertical axis 502, measured in dB, and frequency on a horizontal axis 504, measured in GHz. The data 508 plotted in the chart 500 relates to a simulation where the impedance of the load 404, which is 50 Ohms, is well matched to the signal generator 402. The reflected power varies slightly with frequency, but has a relatively low value of approximately -40dB.

Figure 6 shows a chart 600 illustrating the results of a second simulation performed using the same circuit as for figure 4. Similarly, the chart 600 shows power on a vertical axis 602 and frequency on a horizontal axis 604. The data 608 plotted in the chart 600 relates to a simulation where the impedance of the load, which is 4 Ohms, is not well matched to the signal generator. The reflected power again varies slightly with frequency, but has a significantly higher value of approximately -15dB.

These simulations show that, with appropriate calibration, embodiments of the present disclosure can measure RF power flowing through a transmission line.

Where the RF power sensor apparatus is provided as part of an electronic device, the device may be configured to adapt forward RF power provided to an antenna based on sensed forward RF power and/or sensed reflected RF power sensed by the RF power sensor apparatus. Thereby, the electronic device may be configured to avoid providing an inappropriately high forward power when load matching conditions are not satisfied. The electronic device may therefore avoid sustaining damage to components such as a power amplifier where reflected power could cause overheating or even the destruction of the components concerned.

In some examples, an electronic device may comprise a plurality of antennae. The RF power being transmitted to each antenna may be sensed by an RF power sensor apparatus of the present disclosure. The electronic device may advantageously be configured to adapt both the amplitude of the power transmitted to each antenna and the relative phase of the power transmitted to each antenna.

Examples of electronic devices that may employ embodiments of the present disclosure are diverse, and include devices for providing RF heating (such as microwave ovens) and devices for providing RF communications signalling. A microwave oven may comprise a plurality of antennae. Given that the load supplied to a microwave oven may vary dramatically from time to time, when different items are place in the oven, or when a particular item changes its characteristic as it is heated by the oven, the ability to adapt the phase and/or amplitude of the power supplied to the plurality of antennae may be advantageous. Similarly, a RF communication device may advantageously employ embodiments of the present disclosure to adapt the power provided to an antenna as the location of the device changes and as the impedance of the load of the communication device consequently changes.

It will be appreciated that any components that are described herein as being coupled or connected could be directly or indirectly coupled or connected. That is, one or more components could be located between two components that are said to be coupled or connected whilst still enabling the required functionality to be achieved.

## Claims

1. An RF power sensor apparatus comprising:
a first input-side terminal and a second input-side terminal for connecting to spaced apart regions of an RF transmission line;
a directional coupler comprising:
an input-side coupling line connected to the first input-side terminal via a first capacitor and connected to the second input-side terminal via a second capacitor; and
an output-side coupling line connected to a first output-side terminal and a second output-side terminal;
wherein the input-side coupling line is configured to be electromagnetically coupled to the output-side coupling line, when in use; and
a sensor connected to the first output-side terminal and the second output-side terminal, the sensor configured to sense an RF power coupled from the input-side coupling line to the output-side coupling line when the first input-side terminal and second input-side terminal are coupled to an RF transmission line transmitting RF power.

2. The RF power sensor apparatus of claim 1, selectively configured to sense:
a forward RF power flowing from the first input-side terminal to the second input-side terminal;
a reflected RF power flowing from the second input-side terminal to the first input-side terminal; and
a phase angle between the forward RF power and the reflected RF power.

3. The RF power sensor apparatus of claim 2, wherein the sensor is connected to the first output-side terminal and the second output-side terminal by a switching component comprising:
a first switch configured to selectively couple the first output-side terminal to either the sensor or a first impedance;
a second switch configured to selectively couple the second output-side terminal to either the sensor or a second impedance.

4. The RF power sensor apparatus of claim 3, wherein the switching component further comprises a third switch configured to selectively couple the sensor to either the first switch or the second switch.

5. The RF power sensor apparatus of any preceding claim, wherein the output-side coupling line is one of: less than 2mm, less than 1 mm, less than 0.5mm, less than 0.2mm, or less than 0.1 mm, in length.

6. The RF power sensor apparatus of any preceding claim, wherein the capacitance of the first capacitor is equal to the capacitance of the second capacitor.

7. The RF power sensor apparatus of any preceding claim, wherein the input-side coupling line is capacitively and/or inductively coupled to the output-side coupling line.

8. The RF power sensor apparatus of any preceding claim, wherein the apparatus is configured to sense an RF power in the Gigahertz frequency range.

9. The RF power sensor apparatus of any preceding claim, wherein the apparatus is configured to sense an RF power in the 100W to 10kW power range.

10. The RF power sensor apparatus of any preceding claim, wherein the apparatus is configured, when connected to an RF transmission line transmitting RF power, to couple less than 1%, or less than 0.1%, or less than 0.01%, or less than 0.001%, or less than 0.0001%, of the transmitted RF power from the RF transmission line to the sensor.

11. The RF power sensor apparatus of any preceding claim, wherein the sensor comprises an IQ modulator and/or a diode.

12. The RF power sensor apparatus of claim 1, configured to:
sense a forward RF power flowing from the first input-side terminal to the second input-side terminal; and/or
sense a reflected RF power flowing from the second input-side terminal to the first input-side terminal.

13. An integrated circuit comprising the RF power sensor apparatus of any preceding claim.

14. A device comprising an RF signal generator coupled to an antenna by an RF transmission line, the signal generator configured to supply RF power to the antenna via the RF transmission line, the device further comprising an RF power sensor apparatus comprising:
a first input-side terminal and a second input-side terminal connected to spaced apart regions of the RF transmission line;
a directional coupler comprising:
an input-side coupling line connected to the first input-side terminal via a first capacitor and connected to the second input-side terminal via a second capacitor; and
an output-side coupling line connected to a first output-side terminal and a second output-side terminal;
wherein the input-side coupling line is configured to be electromagnetically coupled to the output-side coupling line, when in use; and
a sensor connected to the first output-side terminal and the second output-side terminal, the sensor configured to sense an RF power coupled from the input-side coupling line to the output-side coupling line when the RF transmission line is transmitting RF power;
wherein, the device is configured to adapt the supply of RF power to the antenna, based on the sensed RF power.

15. A device comprising the RF power sensor apparatus of any of claims 1 to 13, wherein the device is configured to provide RF heating or RF communications signalling.
